# EUROPÄISCHE PATENTSCHRIFT

(11) **EP 0 497 128 B1**
(45) Veröffentlichungstag und Bekanntmachung des Hinweises auf die Patenterteilung: **10.05.1995**
(21) Anmeldenummer: 92100426.3
(22) Anmeldetag: 13.01.1992
(51) Int. Cl.: H05K 13/04

(54) **Vorrichtung zum Bestücken von Leiterplatten**
Device for equipping of circuit boards
Dispositif pour équiper des plaquettes de circuits

(30) Priorität: 28.01.1991 DE 4102458
(43) Veröffentlichungstag der Anmeldung: 05.08.1992
(73) Patentinhaber: SIEMENS AKTIENGESELLSCHAFT, 80333 München (DE)
(72) Erfinder: Pedall, Friedrich, Dipl.-Ing., W-7528 Karlsdorf (DE)

(56) Entgegenhaltungen:
- EP-A- 0 156 150
- GB-A- 2 108 015

## Beschreibung

Aus der DE 34 05 971 A1 ist eine Vorrichtung zum Bestücken von Leiterplatten mit radial bedrahteten Bauelementen bekannt, bei welcher die in gleicher Teilung angeordneten Querstege eines endlos umlaufenden, leiterförmigen Triebes die einzelnen Bauelemente aus in der gleichen Teilung längs des endlosen Triebes angeordneten Zuführeinrichtungen aufnehmen. Die Bauelemente werden dann mit dem endlosen Trieb in eine Übergabeposition transportiert, in welcher ein Bestückkopf das jeweilige Bauelement ergreift und in der zugeordneten Bestückposition auf einer Leiterplatte positioniert. Der taktweise Vorschub des endlosen Triebes und die räumliche Anordnung von Zuführeinrichtungen und Bestückkopf sind derart aufeinander abgestimmt, daß nach jedem Takt jeder Zuführeinrichtung und dem Bestückkopf jeweils ein Quersteg des leiterförmigen Triebes zugeordnet ist.

Aus der DE 32 31 174 A1 ist eine weitere Vorrichtung zum Bestücken von Leiterplatten mit bedrahteten Bauelementen bekannt, bei welcher eine endlos umlaufende Kette in gleichmäßiger Teilung angeordnete Paletten trägt. Diese Paletten nehmen aus längs der Kette in der gleichen Teilung angeordneten Zuführeinrichtungen Bauelemente auf und transportieren sie in eine Übergabeposition, in welcher ein als Revolverkopf mit mehreren Greifelementen ausgebildeter Bestückkopf das jeweilige Bauelement aufnimmt und in der zugeordneten Bestückposition auf einer Leiterplatte positioniert. Der taktweise Vorschub der endlosen Kette und die räumliche Anordnung von Zuführeinrichtungen und Bestückkopf sind auch hier wieder derart aufeinander abgestimmt, daß nach jedem Takt jeder Zuführeinrichtung und dem Bestückkopf jeweils eine Palette zugeordnet ist.

Bei den bekannten Vorrichtungen zum Bestücken von Leiterplatten kann es durch Längungen des zum Transport der Bauelemente eingesetzten endlosen Triebes zu Teilungsfehlern kommen, die ein exaktes Anfahren der Abholpositionen der Zuführeinrichtungen und der Übergabeposition des Bestückkopfes verhindern und somit auch eine sichere Übergabe der Bauelemente verhindern oder zumindest erheblich beeinträchtigen.

Der im Anspruch 1 angegebenen Erfindung liegt das Problem zugrunde, bei einer Vorrichtung zum Bestücken von Leiterplatten mit Bauelementen eine sichere Zufuhr der in verschiedenen Zuführeinrichtungen bereitgestellten Bauelemente zum Bestückkopf zu gewährleisten.

Die mit der Erfindung erzielten Vorteile bestehen insbesondere darin, daß die Abholpositionen und die Übergabeposition von den Transportorganen nicht mehr parallel, sondern unabhängig voneinander seriell angefahren werden. Jede Abholposition und jede Übergabeposition kann somit von jedem Transportorgan programmgesteuert angefahren werden, d. h. das Anfahren von Abholpositionen und Übergabeposition erfolgt mit sehr hoher Genauigkeit, die durch etwaige Längungen des endlosen Triebes nicht beeinträchtigt wird.

Vorteilhafte Ausgestaltungen der Erfindung sind in den Ansprüchen 2-5 angegeben.

Gemäß Anspruch 2 wird als endloser Trieb vorzugsweise ein Zahnriemen verwendet, der bei hinreichender Genauigkeit wesentlich wirtschaftlicher als Ketten und dergleichen eingesetzt werden kann.

Die Verwendung von heb- und senkbaren zangenförmigen Greifern als Transportorgan gemäß Anspruch 3 stellt ebenfalls eine besonders einfache und wirtschaftliche Lösung dar.

Die Ausgestaltung nach Anspruch 4 ermöglicht eine Vorbereitung der jeweiligen Bauelemente innerhalb des Bestückmoduls und damit eine äußerst raumsparende, kompakte Ausbildung der gesamten Bestückvorrichtung.

Gemäß Anspruch 5 können durch die Anordnung einer zusätzlichen Station zum Bearbeiten oder Prüfen der Bauelemente die Möglichkeiten der Bauelemente-Vorbereitung weiter gesteigert werden. Zur Vermeidung von Taktzeitverlusten wird diese zusätzliche Station dann allerdings nicht wie die Abholpositionen und die Übergabeposition unabhängig programmgesteuert angefahren.

Ausführungsbeispiele der Erfindung sind in der Zeichnung dargestellt und werden im folgenden näher beschrieben.

Es zeigen:
- Fig. 1: eine Transporteinrichtung für die Zufuhr von Bauelementen zu einem Bestückkopf in der Abholposition eines Transportorgans,
- Fig. 2: die Transporteinrichtung gemäß Fig. 1 in der Übergabeposition eines Transportorgans,
- Fig. 3: die Zufuhr von Bauelementen mit der in den Fig. 1 und 2 dargestellten Transporteinrichtung zu einem Bestückmodul mit integrierter Bauelemente-Richt- und Drehstation,
- Fig. 4: eine gemäß den Fig. 1 und 2 aufgebaute Transporteinrichtung mit drei nebeneinander angeordneten Zuführeinrichtungen für axial bedrahtete, gegurtete Bauelemente und
- Fig. 5: eine gemäß den Fig. 1 und 2 aufgebaute Transporteinrichtung mit zwei nebeneinander angeordneten Flächenmagazinen als Zuführeinrichtungen für verschiedene Bauelemente.

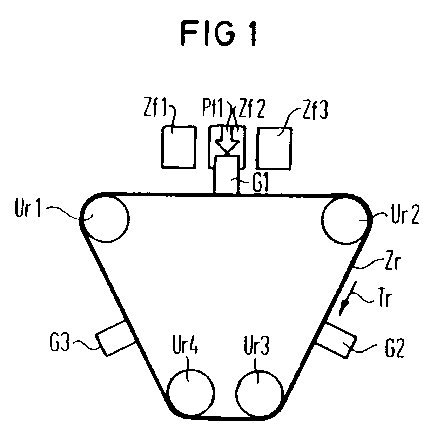

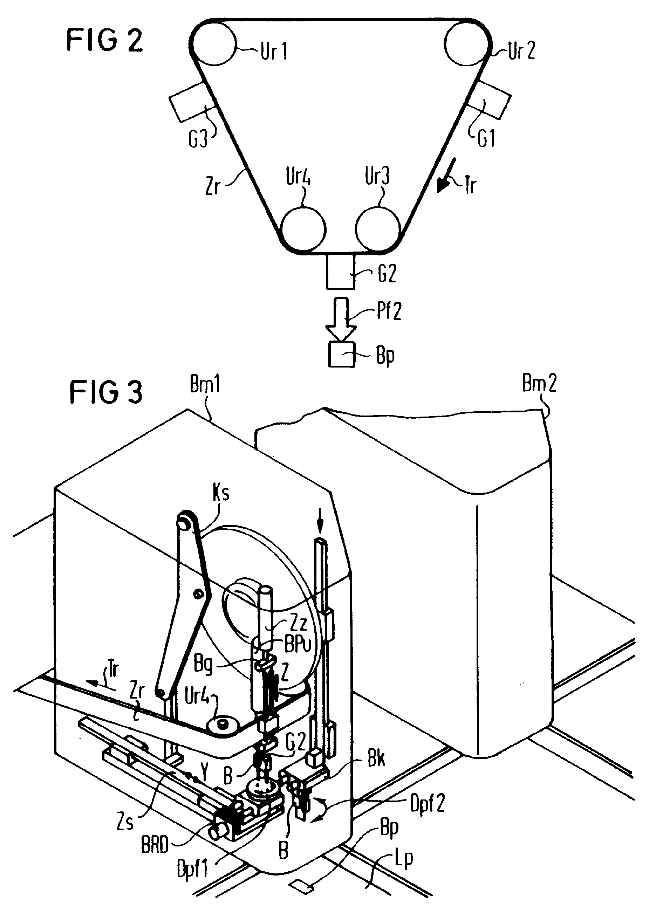

Bei der automatischen Bestückung von Leiterplatten mit Bauelementen sollen einem Bestückkopf auch mehrere geometrisch ähnliche aber elektrisch verschiedene Bauelemente zugeführt werden können. Hierzu werden erfindungsgemäße Transporteinrichtungen eingesetzt, deren Funktionsprinzip nachfolgend anhand der Fig. 1 und 2 erläutert wird.

Gemäß Fig. 1 umfaßt eine derartige Transporteinrichtung einen durch einen Zahnriemen Zr gebildeten endlosen Trieb, der über an den Eckpunkten eines Trapezes angeordnete Umlenkrollen Ur1, Ur2, Ur3 und Ur4 geführt ist und drei im Abstand zueinander angeordnete, zangenförmige Greifer G1, G2 und G3 trägt. Wird eine der Umlenkrollen Ur1 bis Ur4 auf nicht näher dargestellte Weise angetrieben, so werden die zangenförmigen Greifer G1-G3 in der durch einen Pfeil aufgezeigten Transportrichtung Tr verfahren. Im dargestellten Fall befinden sich auf der längeren der beiden parallelen Seiten des Trapezes die in der Zeichnung nicht näher bezeichneten Abholpositionen von Bauelementen aus den Zuführeinrichtungen Zf1, Zf2 und Zf3. Jeder der zangenförmigen Greifer G1-G3 kann jede der Abholpositionen der Zuführeinrichtungen Zf1-Zf3 programmgesteuert anfahren und dort ein entsprechendes Bauelement abholen. Im dargestellten Fall wird mit dem zangenförmigen Greifer G1 die Abholposition der mittleren Zuführeinrichtung Zf2 angefahren, so daß der zangenförmige Greifer G1 dort ein Bauelement aufnehmen kann. Diese Aufnahme eines Bauelements ist durch einen Pfeil Pf1 aufgezeigt. Der zangenförmige Greifer G1 trägt zu diesem Zeitpunkt ein zuvor aus einer der Zuführeinrichtungen Zf1 bis Zf3 entnommenes Bauelement, während der zangenförmige Greifer G3 zu diesem Zeitpunkt leer ist.

Nach der Aufnahme eines Bauelements durch den zangenförmigen Greifer G1 wird der Zahnriemen Zr wieder in Transportrichtung Tr angetrieben und der Greifer G2 fährt dann gemäß Fig. 2 programmgesteuert eine nicht näher bezeichnete Übergabeposition an, die sich im dargestellten Fall in der Mitte zwischen den Umlenkrollen Ur3 und Ur4 befindet. In dieser Übergabeposition übergibt der Greifer G2 das Bauelement an einen an späterer Stelle noch zu erläuternden Bestückkopf, welcher es in einer Bestückposition Bp auf der zugeordneten Leiterplatte absetzt. Diese Übergabe des Bauelements ist in Fig. 2 durch einen Pfeil Pf2 angedeutet. Der zangenförmige Greifer G1 trägt zu diesem Zeitpunkt das zuvor aus der Zuführeinrichtung Zf2 entnommene Bauelement, während der Greifer G2 zu diesem Zeitpunkt noch leer ist.

Nach dem vorstehend beschriebenen Übergabevorgang des vom zangenförmigen Greifer G2 transportierten Bauelements an einen Bestückkopf wird der Zahnriemen Zr wieder in Transportrichtung Tr angetrieben und der Greifer G3 fährt programmgesteuert eine der Abholpositionen der Zuführeinrichtungen Zf1-Zf3 an und übernimmt ein Bauelement, so wie es zuvor am Beispiel des zangenförmigen Greifers G1 beschrieben wurde.

Auf die vorstehend beschriebene Weise können einem Bestückkopf wahlweise drei geometrisch ähnliche, aber elektrisch verschiedene Bauelemente zugeführt werden. Das programmgesteuerte Anfahren der jeweiligen Abholposition bzw. der Übergabeposition erfolgt dabei mit einer äußerst hohen Präzision.

Die in Fig. 2 durch einen Pfeil Pf2 lediglich angedeutete Übergabe eines Bauelements an den Bestückkopf eines Bestückmoduls erfolgt gemäß Fig. 3 über eine in einen Bestückmodul Bml integrierte Bauelement-Richt- und Drehstation BRD. Es ist zu erkennen, daß die Bauelement-Richt- und Drehstation BRD mit einem in Y-Richtung verfahrbaren Zuführschlitten Zs in die Übergabeposition verfahren werden kann, die von dem am Zahnriemen Zr befestigten zangenförmigen Greifer G2 programmgesteuert angefahren wird. Durch Betätigung eines im Bestückmodul Bm1 fest angeordneten Zangenzylinders Zz fährt dessen balkenförmiges Betätigungsglied Bg in Z-Richtung nach unten und bewirkt dadurch eine entsprechende Abwärtsbewegung des zangenförmigen Greifers G2 und die durch einen fest angeordneten Bauelement-Pusher BPu unterstützte Übergabe eines Bauelements B an die Bauelement-Richt- und Drehstation BRD. In dieser Station kann das übergebene Bauelement B um ± 180° verdreht werden, wobei diese Verdrehmöglichkeit durch einen Doppelpfeil Dpf1 aufgezeigt ist. Nach der Übergabe und einer gegebenenfalls vorzunehmenden Verdrehung des Bauelements B wird der Zuführschlitten Zs über eine Kurvenschwinge Ks angetrieben und in Y-Richtung nach vorne in die Greifposition des Bestückkopfes Bk verfahren. Angetrieben von einer in Fig. 3 nicht erkennbaren zweiten Kurvenschwinge fährt der Bestückkopf Bk dann nach unten über das Bauelement B und ergreift es. In dieser gegriffenen Stellung werden die Anschlußdrähte des Bauelements B dann auf übliche Weise, beispielsweise durch plastisches Verbiegen in eine definierte Lage zum Bestückkopf Bk des Bestückmoduls Bm1 gebracht. Der Bestückkopf Bk entnimmt dann das Bauelement B aus der Bauelement-Richt- und Drehstation BRD und positioniert es durch Absenken in Z-Richtung in der Bestückposition Bp einer Leiterplatte Lp.

Das vom Bestückkopf Bk erfaßte Bauelement B kann mit dem Bestückkopf Bk um ± 90° verdreht werden, wobei diese Drehmöglichkeit durch einen Doppelpfeil Dpf2 aufgezeigt ist. Durch eine Kombination der Drehmöglichkeiten Dpf1 und Dpf2 ist insgesamt eine Verdrehung des Bauelements B um 360° in 90°-Schritten möglich.

In Fig. 3 ist durch einen im Abstand zum Bestückmodul Bm1 angeordneten zweiten Bestückmodul Bm2 angedeutet, daß eine Vorrichtung zum Bestücken von Leiterplatten auch zwei oder mehrere Bestückmodule umfassen kann.

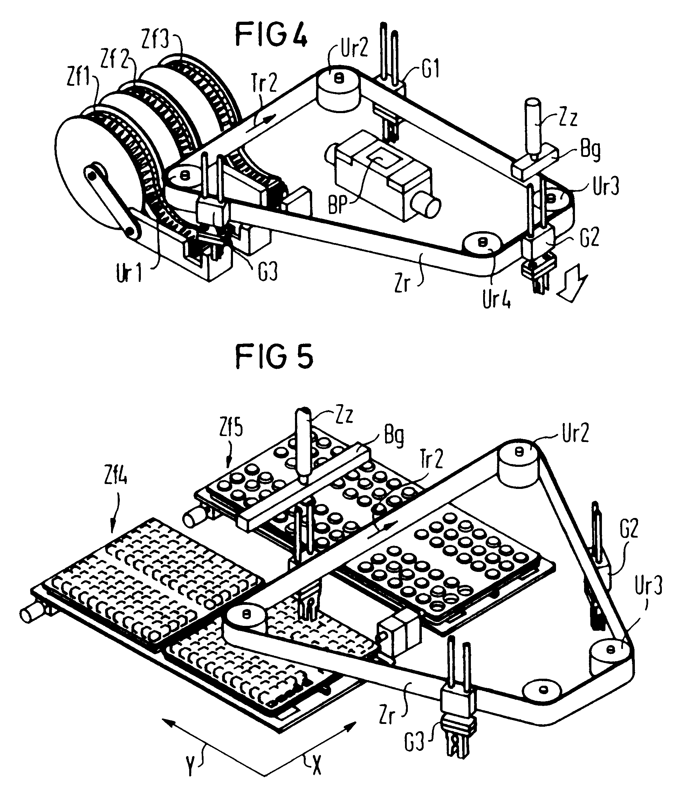

Fig. 4 zeigt drei nebeneinander angeordnete Zuführeinrichtunggen Zf1, Zf2 und Zf3 für axial bedrahtete, gegurtete Bauelemente. Aus den Abholpositionen dieser drei in üblicher Weise aufgebauten Zuführeinrichtungen Zf1, Zf2 und Zf3 werden die jeweils benötigten Bauelemente von den zangenförmigen Greifern G1, G2 und G3 entnommen und zu der Übergabeposition transportiert, die sich beispielsweise, wie es im Zusammenhang mit Fig. 3 beschrieben wurde, im Bestückmodul Bm1 befindet. Im dargestellten Fall befindet sich gerade der zangenförmige Greifer G2 in dieser Übergabeposition. Es ist auch zu erkennen, daß der Abstand zum nachfolgenden zangenförmigen Greifer G1 derart bemessen ist, daß dieser sich unmittelbar über einer zusätzlichen Station zum Bearbeiten oder Prüfen der Bauelemente befindet, wenn der Greifer G2 die Übergabeposition programmgesteuert anfährt. In dieser zusätzlichen Station BP kann dann beispielsweise eine elektrische Funktionsprüfung der Bauelemente vorgenommen werden.

Fig. 5 zeigt die Bereitstellung von Bauelementen in zwei nebeneinander angeordneten Zuführeinrichtungen Zf4 und Zf5, die als Flächenmagazine ausgebildet sind. Im dargestellten Fall hat der zangenförmige Greifer G1 gerade programmgesteuert eine der Zuführeinrichtung Zf4 zugeordnete Abholposition in X-Richtung angefahren, aus welcher er dann ein entsprechendes Bauelement entnehmen kann. Die Bereitstellung der verschiedenen Bauelemente in den Flächenmagazinen erfolgt durch deren Verschiebung in Y-Richtung. Die Betätigung des zangenförmigen Greifers G2 erfolgt auch hier durch einen ortsfest angeordneten Zangenzylinder Zz, dessen balkenförmiges Betätigungsglied Bg so breit ist, daß es beide den Zuführeinrichtungen Zf4 und Zf5 zugeordnete Abholpositionen überdeckt. In den als Flächenmagazinen ausgebildeten Zuführeinrichtungen Zf4 und Zf5 können beispielsweise Bauelemente wie Transformatoren, Drosseln und dergleichen bereitgestellt werden.

## Patentansprüche

1. Vorrichtung zum Bestücken von Leiterplatten (Lp) mit Bauelementen (B), mit
- mindestens einer Zuführeinrichtung (Zf1-Zf3, Zf4, Zf5) zum Bereitstellen von Bauelementen in mindestens einer Abholposition,
- mindestens zwei an einem endlosen Trieb im Abstand zueinander angeordneten Transportorganen, welche die Bauelemente (B) aus einer Abholposition entnehmen, zu einer Übergabeposition transportieren und in dieser Ubergabeposition abgeben,
- mindestens einem Bestückmodul (Bm1), dessen Bestückkopf (Bk) die Bauelemente (B) in der Ubergabeposition aufnimmt und auf einer relativ zum Bestückkopf (Bk) in Bestückposition ausgerichteten Leiterplatte (Lp) positioniert, wobei
- die Abstände zwischen den Transportorganen derart gewählt sind, daß die Abhol- und Übergabepositionen von den Transportorganen programmgesteuert und unabhängig voneinander seriell anfahrbar sind.

2. Vorrichtung nach Anspruch 1, **dadurch gekennzeichnet**, daß der endlose Trieb durch einen Zahnriemen (Zr) gebildet ist.

3. Vorrichtung nach Anspruch 1 oder 2, dadurch gekennzeichnet, daß die Transportorgane durch relativ zum endlosen Trieb heb- und senkbare zangenförmige Greifer (G1-G3) gebildet sind.

4. Vorrichtung nach einem der vorhergehenden Ansprüche, dadurch gekennzeichnet, daß die Ubergabeposition durch eine in den Bestückmodul (Bm1) integrierte Bauelement-Richt- und Drehstation (BRD) gebildet ist, in welche die Transportorgane die Baueelemente (B) absetzen und aus welcher der Bestückkopf (Bk) die Bauelemente (B) entnimmt.

5. Vorrichtung nach einem der vorhergehenden Ansprüche, dadurch gekennzeichnet, daß an dem endlosen Trieb mindestens drei im Abstand zueinander angeordnete Transportorgane angebracht sind und daß in Transportrichtung (Tr) des endlosen Triebes gesehen zwischen Abholposition und Übergabepostion eine zusätzliche Station (BP) zum Bearbeiten oder Prüfen der Bauelemente (B) derart angeordnet ist, daß beim programmgesteuerten Anfahren der Übergabeposition das nachfolgende Transportorgan diese zusätzliche Station (BP) anfährt.

## Claims

1. Device for populating printed circuit boards (Lp) with components (B), having
- at least one feeding device (Zf1-Zf3, Zf4, Zf5) for providing components in at least one collecting position,
- at least two transport members which are arranged at a distance from each other on an endless drive mechanism and which remove the components (B) from a collecting position, transport them to a transfer position and deliver them in this transfer position,
- at least one populating module (Bm1) whose populating head (Bk) takes up the components (B) in the transfer position and positions them on a printed circuit board (Lp) which is aligned with respect to the populating head (Bk) in the populating position,
- the distances between the transport members being selected in such a manner that the collecting position and the transfer position can be serially approached by the transport members independently of each other and in a program-controlled manner.

2. Device according to Claim 1, characterized in that the endless drive mechanism is formed by a toothed belt (Zr).

3. Device according to Claim 1 or 2, characterized in that the transport members are formed by tong-like grippers (G1-G3) which can be raised and lowered with respect to the endless drive mechanism.

4. Device according to one of the preceding claims, characterized in that the transfer position is formed by a component-aligning and component-rotating station (BRD), which is integrated in the populating module (Bm1) and into which the transport members deposit the components (B) and from which the populating head (Bk) removes the components (B).

5. Device according to one of the preceding claims, characterized in that at least three transport members, which are arranged at a distance from each other, are fitted on the endless drive mechanism, and in that, seen in the transport direction (Tr) of the endless drive mechanism, an additional station (BP) for treating or testing the components (B) is arranged between the collecting position and transfer position in such a manner that during program-controlled approach of the transfer position the subsequent transport member approaches this additional station (BP).

## Revendications

1. Dispositif pour équiper des plaquettes à circuits imprimés (Lp) de composants (B), comportant
- au moins un dispositif d'amenée (Zf1 à Zf3, Zf4, Zf5) pour mettre des composants dans au moins une position de prélèvement,
- au moins deux éléments de transport, qui sont disposés à distance l'un de l'autre sur un dispositif d'entraînement sans fin et qui enlèvent les composants (B) d'une position de prélèvement, les transportent jusqu'à une position de transfert et les relâchent dans cette position de transfert,
- au moins un module d'équipement (Bm1), dont la tête d'équipement (Bk) reçoit les composants (B) dans la position de transfert et les met en position sur une plaquette à circuits imprimés (Lp) orientée en position d'équipement par rapport à la tête d'équipement (Bk).
- les distances entre les éléments de transport étant choisies de telle sorte que les positions de prélévement et de transfert peuvent être atteintes successivement d'une manière programmée et indépendamment l'une de l'autre par les éléments de transport.

2. Dispositif suivant la revendication 1, caractérisé par le fait que le dispositif d'entraînement sans fin est constitué d'une courroie dentée (Zr).

3. Dispositif suivant la revendication 1 ou 2, caractérisé par le fait que les éléments de transport sont formés par des organes de préhension en forme de pinces (G1 à G3), qui peuvent être soulevés et abaissés par rapport au dispositif d'entraînement sans fin.

4. Dispositif suivant l'une des revendications précédentes, caractérisé par le fait que la position de transfert est formée par un poste de redressement et de rotation des composants (BRD), qui est intégré à un module d'équipement (Bm1), dans lequel les éléments de transport déposent les composants (B) et duquel la tête d'équipement (Bk) enlève les composants (B).

5. Dispositif suivant l'une des revendications précédentes, caractérisé par le fait qu'au moins trois éléments de transport distants les uns des autres sont disposés sur le dispositif d'entraînement sans fin et que, lorsqu'on regarde dans la direction de transport (Tr) du dispositif d'entraînement sans fin, entre une position de prélèvement et une position de transfert est disposé un poste supplémentaire (BP) servant à traiter ou contrôler les composants (B) de telle sorte que, dans le cas où l'on atteint d'une manière programmée la position de transfert, I'élément de transport suivant atteint ce poste supplémentaire (BP).
